# EUROPEAN PATENT SPECIFICATION

(11) **EP 4 578 068 B1**
(45) Date of publication and mention of the grant of the patent: **11.11.2026**
(21) Application number: 23738247.8
(22) Date of filing: 01.06.2023
(51) Int. Cl.: H01Q 1/22, H01Q 21/00, H01Q 3/26, H01Q 21/06, H01Q 1/52, H10W 44/20, H10W 42/20, H10W 90/20, H10W 90/00, H10W 90/22, H10W 70/60

(54) **METHOD OF CREATING EMBEDDED COMPONENTS ON AN ANTENNA SUBSTRATE AND ANTENNA APPARATUS FORMED WITH SAME**
VERFAHREN ZUR ERZEUGUNG EINGEBETTETER KOMPONENTEN AUF EINEM ANTENNENSUBSTRAT UND DAMIT GEFORMTE ANTENNENVORRICHTUNG
PROCÉDÉ DE CRÉATION DE COMPOSANTS INTÉGRÉS SUR UN SUBSTRAT D'ANTENNE ET APPAREIL D'ANTENNE FORMÉ AVEC CELUI-CI

(30) Priority: 07.09.2022 US 202263404395 P
(43) Date of publication of application: 02.07.2025
(73) Proprietor: ViaSat, Inc., Carlsbad, CA 92009 (US)
(72) Inventor: FRANSON, Steven J., Carlsbad, CA 92009 (US); PETTIT, David E., Carlsbad, CA 92009 (US)
(74) Representative: Beal, James Michael
(86) International application number: PCT/US2023/024215
(87) International publication number: WO 2024/054268

(56) References cited:
- US-A1- 2009 168 367
- US-A1- 2017 048 981
- US-A1- 2021 005 977

## Description

### TECHNICAL FIELD

This disclosure relates generally to antennas and more particularly to a method of creating embedded components on an antenna substrate of an antenna apparatus.

### DISCUSSION OF RELATED ART

Antenna arrays are currently deployed in a variety of applications at microwave and millimeter wave frequencies, such as in aircraft, satellites, vehicles, and base stations for general land-based communications. Such antenna arrays typically include microstrip radiating elements driven with phase shifting beamforming circuitry to generate a phased array for beam steering. In many cases it is desirable for an entire antenna system, including the antenna array and beamforming circuitry, to occupy minimal space with a low profile while still meeting requisite performance metrics. To this end, a thin, generally planar structure for an antenna apparatus is desirable. The structure may have a sandwich type configuration including antenna elements disposed in an exterior facing component layer and integrated circuits (ICs) distributed across a parallel component layer behind the antenna element layer. The ICs may include RFICs with front end circuitry such as RF power amplifiers (PAs) for transmit operations, low noise amplifiers (LNAs) for receive operations, and phase shifters for beam steering. It is desirable for the RFICs to be close to the antenna elements for optimum performance. Other ICs of the antenna apparatus, such as field programmable gate arrays (FPGAs), may include circuitry providing biasing and control signals to the RFICs, or baseband / digital signal processing circuitry.

US 2021/005977 A1 describes a low profile antenna apparatus.

### SUMMARY

In an aspect of the presently disclosed technology, an antenna apparatus includes an antenna substrate having a first surface and a second surface on opposite sides. A plurality of antenna elements are formed on the first surface, and a plurality of vias are formed within the antenna substrate. The antenna apparatus further includes a beamforming network (BFN) including a plurality of semiconductor components, each having a third surface facing the antenna substrate; and metal pillars attaching the second surface to the third surface to thereby attach the semiconductor components to the antenna substrate. The semiconductor components are radio frequency (RF) coupled to the antenna elements through the vias. Molding material is formed on the second surface and at least partially encapsulates each of the semiconductor components.

In another aspect, a method of forming an antenna apparatus includes: providing an antenna substrate having a first surface and a second surface on opposite sides; forming a plurality of antenna elements on the first surface; forming vias within the antenna substrate and connecting the vias on first ends thereof to the plurality of antenna elements; attaching, through metal pillars, a plurality of semiconductor components to the second surface and to second ends of the vias, where the semiconductor components are part of a beamforming network; and forming molding material on the second surface, at least partially encapsulating each of the plurality of semiconductor components.

### BRIEF DESCRIPTION OF THE DRAWINGS

The above and other aspects and features of the disclosed technology will become more apparent from the following detailed description, taken in conjunction with the accompanying drawings in which like reference numerals indicate like elements or features. Various elements of the same or similar type may be distinguished by annexing the reference label with an underscore / dash and second label that distinguishes among the same / similar elements (e.g., _1, _2), or directly annexing the reference label with a second label. However, if a given description uses only the first reference label, it is applicable to any one of the same / similar elements having the same first reference label irrespective of the second label. Elements and features may not be drawn to scale in the drawings.
FIG. 1 is a perspective view of an example antenna apparatus according to an embodiment.
FIG. 2 is an example schematic diagram of the antenna apparatus of FIG. 1.
FIGS. 3A and 3B illustrate respective examples of a plan view and a schematic diagram of a beamforming network (BFN) component subset within the antenna apparatus of FIG. 1.
FIG. 4 is a cross-sectional view of a portion of the antenna apparatus of FIG. 1, depicting an example internal structure.
FIGS. 5A and 5B are example cross-sectional views of a portion of the antenna apparatus of FIG. 1, depicting other examples of internal structures, which include radiation shielding.
FIG. 5C is another example cross-sectional view of a portion of the antenna apparatus of FIG. 1, depicting still another example internal structure.
FIG. 6 is a flow diagram of an example method for fabricating an antenna apparatus according to an embodiment.
FIG. 7 is a flow diagram of an example method of fabricating an antenna apparatus having structures illustrated in FIGS. 4 or 5 according to an embodiment.
FIGS. 8A, 8B, 8C, 8D, 8E, 8F, 8G, 8H and 8I are cross-sectional views illustrating respective steps in the method of forming the antenna apparatus of FIG. 7.
FIG. 9 is a cross-sectional view of a portion of the antenna apparatus of FIG. 1, depicting still another example internal structure.
FIG. 10A is a cross-sectional view of the region "A" of FIG. 9, depicting an example interconnection structure between a via or metal pillar to a multi-layer region of an antenna substrate.
FIG. 10B is a cross-sectional view of the region "B" of FIG. 9, depicting an example interconnection structure between a via or metal pillar to a deeper layer of the multi-layer region.
FIG. 10C is a cross-sectional view of the region "C" of FIG. 9, depicting an example interconnection structure between a metal pillar to an antenna feed via within the antenna substrate.

### DETAILED DESCRIPTION OF EMBODIMENTS

The following description, with reference to the accompanying drawings, is provided to assist in a comprehensive understanding of certain exemplary embodiments of the technology disclosed herein for illustrative purposes. The description includes various specific details to assist a person of ordinary skill the art with understanding the technology, but these details are to be regarded as merely illustrative. For the purposes of simplicity and clarity, descriptions of well-known functions and constructions may be omitted when their inclusion may obscure appreciation of the technology by a person of ordinary skill in the art.

Herein, the "/" symbol between a first element and a second element means that both the first and second elements are present in one example, but only the first element or only the second element is present in other examples.

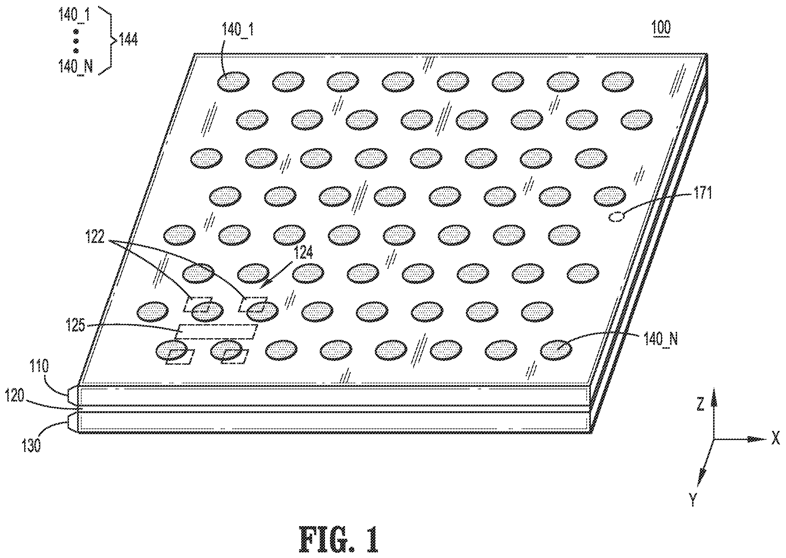

FIG. 1 is a perspective view of an example antenna apparatus, 100, according to an embodiment. Antenna apparatus 100 is configured in a platelike sandwich structure that includes an antenna substrate 110, a printed wiring board assembly (PWB) 130, and a beamforming network (BFN) 120 in the form of a component layer between the antenna substrate 110 and PWB 130. A plurality N of antenna elements 140_1 to 140_N are formed on antenna substrate 110 to form a planar (two dimensional) antenna array 144. Antenna apparatus 100 may have a thin profile with a thickness (in the vertical, z direction) at least one order of magnitude less than its length and its width (x and y directions).

BFN 120 may include individual semiconductor chips 122 and other components, such as those of a BFN component subset 124, horizontally distributed (in the xy plane) behind antenna elements 140. In an example, each BFN component subset 124 may include semiconductor chips 122, hereafter exemplified and referred to as amplifier chips 122, and other BFN circuitry 125 including at least one phase shifter chip. Control circuitry on PWB 130 may provide biasing voltages to amplifiers and control signals to phase shifters and other components within BFN 120. Antenna apparatus 100 may be configured as a transmitting antenna system, a receiving antenna system, or both a transmitting and receiving antenna system. In the transmit direction, an input radio frequency (RF) signal at an input port 171 (within PWB 130 or BFN 120) may be divided, phase shifted and amplified into N transmit signals by BFN 120. Each of the divided signals may be radiated by a respective one of antenna elements 140_1 to 140_N. Reciprocal operations may occur in the receive direction.

Briefly, the amplifier chips 122 and other circuitry of BFN 120 are at least partially encapsulated by molding material, described below, which allows for BFN 120 to be formed as a thin layer with planar surfaces on opposite sides. Electrical connections between the amplifier chips and at least the antenna substrate 110 may be made with relatively small metal pillars or bumps (e.g., copper pillars), formed on amplifier chips 122 or the antenna substrate. The metal pillars may also be encapsulated with the molding material. The construction facilitates electrical connection of the semiconductor chips with antenna elements 140 and the control circuitry of PWB 130, enabling antenna apparatus 100 to be constructed in a space efficient manner with a thin profile. In addition, methods for fabricating antenna apparatus 100 as described below may exhibit certain advantages over related art methods for forming similar type antennas.

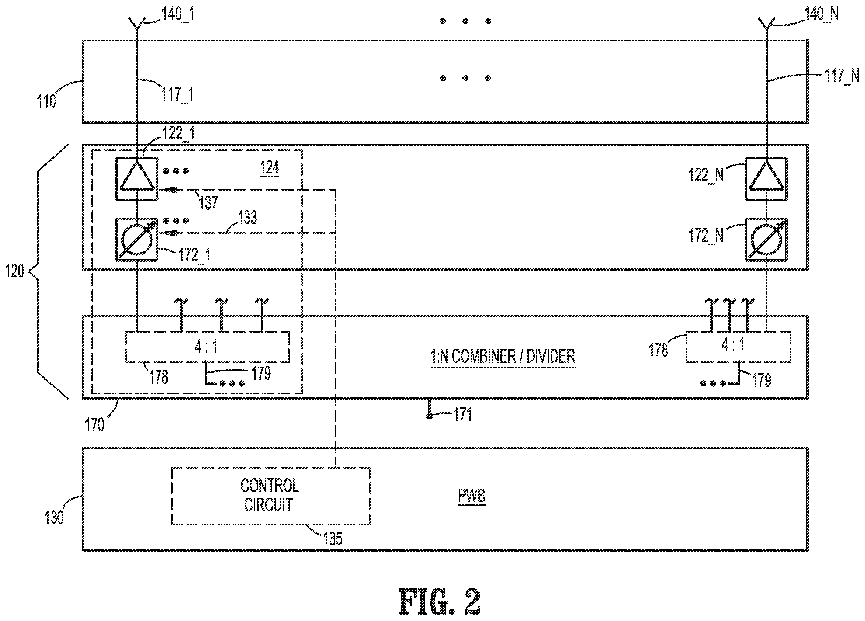

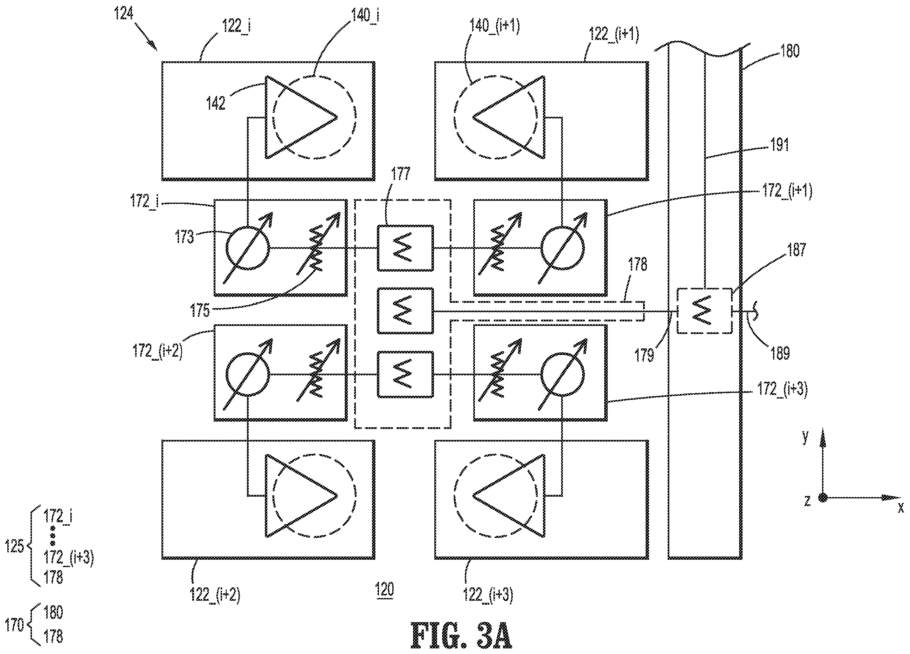

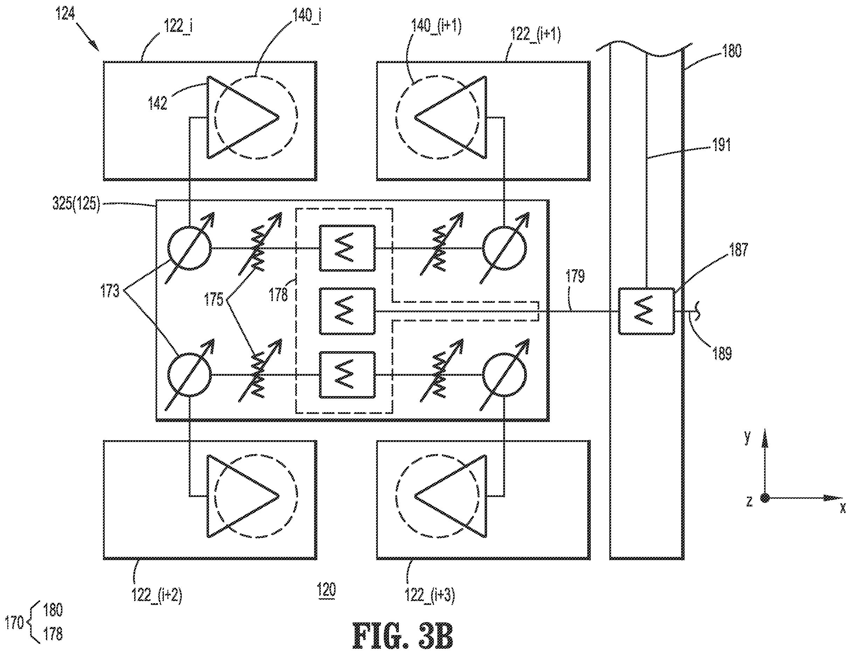

FIG. 2 is an example schematic diagram of antenna apparatus 100, and FIGS. 3A and 3B illustrate example plan views and schematics of BFN component subset 124. Referring collectively to FIGS. 1-3B, BFN 120 may include a 1:N combiner/divider 170, N amplifier chips 122_1 to 122_N, and N phase shifters 173. As shown in FIG. 3A, each phase shifter 173 may be included in a respective one of phase shifter chips 172_1 to 172_N. Alternatively, as shown in FIG. 3B, each phase shifter 173 is one of a plurality of phase shifters 173 of a larger phase shifter chip 325 (an example of BFN circuitry 125). Each amplifier chip 122 and/or phase shifter chip 172/325 may be an RF integrated circuit (RFIC) or a monolithic microwave integrated circuit (MMIC). Any phase shifter chip 172/325 may include both a phase shifter 173 and one or more variable attenuators 175. Any amplifier chip 122 may include at least one amplifier 142, e.g., at least one power amplifier (PA) in the case of a transmit-only antenna system, at least one low noise amplifier (LNA) in the case of a receive-only antenna system, or both a PA(s) and an LNA(s) for a transmit and receive antenna system. Amplifier chips 122 and phase shifter chips 172/325 may be primarily composed of different respective semiconductor materials. In one example, amplifier chips 122 are primarily composed of indium phosphide (InP) and phase shifter chips 172 are primarily composed of silicon, e.g., including complementary metal oxide semiconductor (CMOS) transistors.

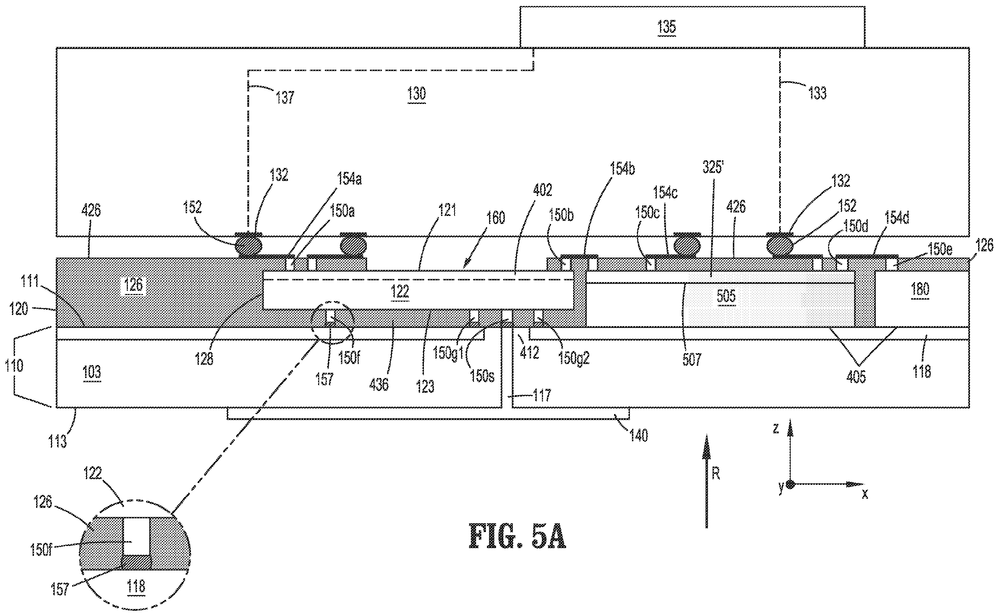

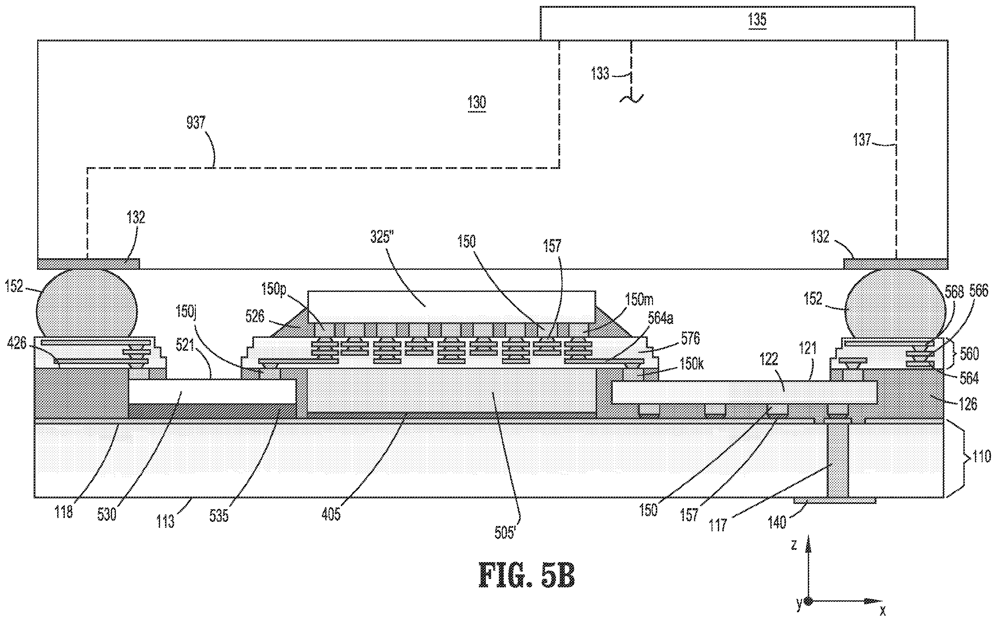

In other examples, at least one amplifier 142, at least one phase shifter 173, and at least one variable attenuator 142 are included within a single semiconductor chip. However, one benefit of providing amplifier(s) 142 and phase shifters 173 in separate InP and silicon chips is that the silicon chips may be made thinner. For space-based applications, this clears up real estate in BFN 120 to incorporate a radiation shield, as described later with reference to FIGS. 5A and 5B, which may be disposed adjacent to a silicon chip to protect the phase shifter circuitry from radiation in space-based and other applications.

The amplitude and phase of signals transmitted to / received by each antenna element 140_i (i = any of 1 to N) may be controlled by an individual amplifier 142, a phase shifter 173 and a variable attenuator 175. To this end, PWB 130 may include a control circuit 135 such as a field programmable gate array (FPGA) to provide logic voltages to phase shifter chips 172/325 to set phase shifts and attenuation, and variable / calibrated bias voltages to amplifier chips 122, as illustrated by paths 137 and 133. Amplifier chips 122_1 to 122_N may be RF coupled to antenna elements 140_1 to 140_N through vias 117_1 to 117_N, respectively, which may extend through antenna substrate 110 to form probe feeds for the antenna elements. In some embodiments, multiple vias 117 connect to each antenna element to provide multiple polarization and or circular polarization, in which case there are (Z x N) vias 117, where Z may be two or more. In an alternative embodiment, vias 117 extend only partially through antenna substrate 110 and electromagnetically (EM) excite antenna elements 140 to RF couple amplifier chips 122 with antenna elements 140.

The 1:N combiner/divider 170 may be at least partially distributed on transmission line structures 180 / 178 that occupy horizontal areas between the amplifier chips 122 and/or the phase shifter chips 172. For instance, in the example layout of FIG. 3A, amplifier chips 122 and phase shifter chips 172 are grouped in BFN component subsets 124 of four amplifier chips 122_i to 122_(i+3), four phase shifter chips 172_i to 172_(i+3) in a region between the four amplifier chips, and a 4:1 combiner/divider 178 in a region between the four phase shifter chips. A remaining portion of combiner/divider 170 may be formed by transmission line structure 180, hereafter "combiner/divider section 180". The 4:1 combiner/divider 178 may be formed by three 2:1 combiner/dividers 177 (e.g., hybrid couplers, Wilkinson couplers, etc.). (Note that the BFN circuitry 125 illustrated in FIG. 1 may include the four phase shifter chips 172_i to 172_(i+1) and one 4:1 combiner/divider 178.) An input/output (I/O) line 179 of 4:1 combiner/divider 178 may connect to another 2:1 combiner/divider 187 within combiner/divider section 180. In the layout of FIG. 3B, four phase shifters 173, four variable attenuators 175, and combiner/divider 178 may be included in the single phase shifter chip 325.

In the transmit direction, 2:1 combiner/divider 187 may divide an RF transmit signal on a transmission line 191 into a first divided signal applied to I/O line 179 and a second divided signal applied to an I/O line 189 which leads to another BFN component subset 124 (not shown). Reciprocal signal flow may occur in the receive direction. In this manner, an input transmit signal applied to I/O port 171 may be divided equally or unequally to antenna elements 140_1 to 140_N. And, in the receive path, N element signals received by antenna elements 140_1 to 140_N may be combined to provide a composite receive signal (output signal) at I/O port 171. The transmission line structures of combiner/divider section 180; 2:1 combiner 187, transmission line 191, etc. (a portion of combiner/divider 170, hereafter, "combiner/divider section 180", as well as 4:1 may be microstrip or coplanar waveguide (CPW) structures including a dielectric substrate such as alumina, and metallization to form inner ("signal") conductors and outer ("ground") conductors. In one example, combiner/divider section 180 is thereby configured by a unitary transmission line structure. In another example, combiner/divider section 180 is formed with multiple transmission line sections pieced together by suitable electrical connections between respective inner conductors and between respective outer conductors of adjacent transmission line sections (if necessary).

In another example, additional intermediate amplifiers in the transmit and/or receive direction are employed at various points within combiner/divider 170 as desired. For instance, an amplifier chip (e.g., 530 of FIG. 5B discussed later) including an intermediate amplifier may be inserted between I/O line 179 of 4:1 combiner/divider 178 and 2:1 combiner/divider 187; another amplifier chip with an intermediate amplifier may be inserted between 2:1 combiner/divider 187 and I/O line 189; and so forth. Each of these amplifier chips may be at least partially encapsulated with molding material in the same manner as described below for amplifier chips 122.

Antenna elements 140, when embodied as microstrip patches, may have any suitable shape such as circular, square, rectangular, elliptical or variations thereof, and may be fed and configured in a manner sufficient to achieve a desired polarization, e.g., circular, linear, or elliptical. The number N of antenna elements 140, their type, sizes, shapes, inter-element spacing, and the manner in which they are fed may be varied by design to achieve targeted performance metrics. In a typical embodiment antenna apparatus 100 may include tens, hundreds or thousands of antenna elements 140. In embodiments described below, each antenna element 140 is a microstrip patch fed with a probe feed (which herein encompasses a side feed to the patch), implemented with a via. In other examples, an electromagnetic feed mechanism is used instead of a via, where each antenna element 140 is excited from a respective feed point with near field energy.

Antenna apparatus 100 may be configured for operation over a millimeter (mm) wave frequency band, generally defined as a band within the 30 GHz to 300 GHz range. In other examples, antenna 100 operates in a microwave range from about 1 GHz to 30 GHz, or in a sub-microwave range below 1 GHz. Herein, an RF signal denotes a signal with a frequency anywhere from below 1 GHz up to 300 GHz.

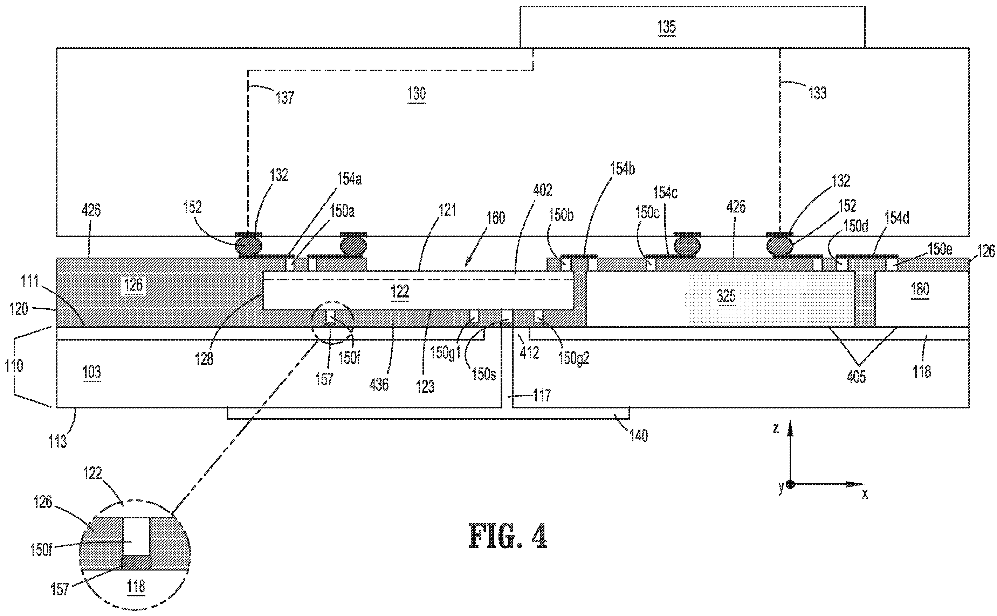

FIG. 4 is a cross-sectional view of a portion of antenna apparatus 100, depicting an example internal structure. The same general construction shown in FIG. 4 may be used throughout the entirety of antenna apparatus 100. Accordingly, the description below referring to a single amplifier chip 122, phase shifter chip 325/172, etc. may apply to all amplifier chips 122, phase shifter chips 325/172, etc. within antenna apparatus 100. The cross-sectional view is flipped relative to the orientation of FIG. 1, thus the relative terms "upper" and "lower" in the following discussion will refer to the view of FIG. 4.

Molding material 126 may partially or fully encapsulate amplifier chip 122, phase shifter chip 325, and combiner/divider section 180. However, an air gap may have been intentionally formed directly above a central (e.g., majority) portion 160 of an upper surface 121 of amplifier chip 172. An active region 402 of amplifier chip 122 with active circuitry (e.g., doped regions of transistors forming drain to source conductive channels, etc.) may be located directly behind upper surface 121. The majority or substantially the entirety of active region 402 may interface with the air gap rather than molding material 126, allowing for better thermal dissipation of the active circuitry. Some examples of molding material 126 include molding materials typically used in Fan Out Wafer Level Packaging (FOWLP); an epoxy mold compound (EMC); a liquid crystal polymer (LCP); and other plastics such as polyimide.

Antenna substrate 110 has a lower surface 113 upon which antenna elements 140 may have been formed. Antenna elements 140 may be any suitable type of radiating elements such as patch antenna elements or printed dipoles. An upper surface 111 of antenna substrate 110 is attached to amplifier chip 122, phase shifter chip 325 and combiner/divider section 180. An antenna ground plane 118 may be located at the upper portion of antenna substrate 110 and form at least a part of upper surface 111. The remainder, i.e., lower portion 103, of antenna substrate 110 may be a low loss dielectric such as quartz, glass or fused silica. The attachment of antenna substrate 110 to a lower surface 123 of amplifier chip 122 is through metal pillars (or bumps) 150, such as metal pillars 150f, 150s, 150g1 and 150g2. Examples of metal pillars 150 include copper pillars, gold pillars, platinum pillars and mixed alloy pillars.

In the example illustrated in FIG. 4, metal pillars 150 are formed on lower surface 123 of amplifier chip 122, and a solder cap 157 is formed on each lower surface of these metal pillars 150. When melted, solder caps 157 adhere the respective metal pillars 150f, 150g1 and 150g2 to electrical connection points on ground plane 118 to form electrical and mechanical connections. Upper surfaces of metal pillars 150f, 150g1 and 150g2 may electrically connect to ground contacts (not shown) within amplifier chip 122. An upper surface of metal pillar 150s electrically connects to a "signal contact" (not shown) within amplifier chip 122. Via 117 has a lower end connected to antenna element 140 and an upper end connected to metal pillar 150s through a solder cap 157 on metal pillar 150s, to form a probe feed for antenna element 140. Metal pillars 150s, 150g1 and 150g2 may form a "ground-signal-ground" (GSG) transition (or "GSG connection") between amplifier chip 122 and antenna substrate 110. A dielectric or air region 412 may annularly surround the upper end of via 117 to isolate the same from ground plane 118 and complete the GSG transition. Alternatively, one of metal pillars 150g1 or 150g2 is omitted, whereby a ground-signal (GS) transition is substituted for the GSG transition.

The lower metal pillars 150f, 150g1 and 150g2 may be alternatively formed on ground plane 118, and metal pillar 150s may be alternatively formed on the upper end of via 117. In this case, solder caps 157 may be disposed on the upper surfaces of the lower metal pillars 150 for connection to respective metal contacts on lower surface 123 of amplifier chip 122. Whether the lower metal pillars 150 are pillars formed on the lower surface 123 of amplifier chip 122 or the upper surface 111 of antenna substrate 110, a region 436 surrounding the lower metal pillars 150f, etc. may be filled with molding material 126. Alternatively, region 436 is filled with an underfill material different from molding material 126. In another embodiment, region 436 is an air-filled region. The underfill material may be a dielectric material that acts as a glue. Examples include epoxy materials with a silicon filler designed to minimize coefficient of thermal expansion (CTE) mismatch.

Phase shifter chip 325 and combiner/divider section 180 may each be attached to antenna substrate 110 with a suitable adherent 405 such as a solder cap layer or an adhesive. Upper metal pillars such as 150a and 150b may be formed on upper surface 121 of amplifier chip 122. Similarly, upper metal pillars such as 150c, 150d and 150e may be formed on upper surfaces of phase shifter chip 325 and combiner/divider section 180. The upper surface 121 of amplifier chip 122 may be coplanar with upper surfaces of phase shifter chip 325 and combiner/divider section 180. Upper metal pillars such as 150a to 150e may be formed with substantially uniform dimensions, such that their upper surfaces are also coplanar. Molding material 126 may surround and interface with peripheral surfaces 128 of amplifier chip 122 (orthogonal to upper surface 121 and lower surface 123) as well as peripheral surfaces of phase shifter chip 325 and combiner/divider section 180. Molding material 126 may also extend uniformly above upper surface 121 of amplifier chip 122 and cover peripheral portions of upper surface 121 (outside the periphery of central portion 160). Molding material 126 may also be uniformly disposed on top surfaces of phase shifter chip 325 and combiner/divider section 180, such that a top surface 426 of molding material 126 is coplanar with different regions thereof (regions atop amplifier chip 122, phase shifter chip 325, etc.) and is coplanar with the upper surfaces of upper metal pillars 150a to 150e. In this manner, a redistribution layer (RDL) 154 (including conductive traces 154a to 154d, etc.) formed atop surface 426 may electrically connect desired metal pillars between separated BFN components. For instance, metal pillar 150d of phase shifter chip 325 may connect to metal pillar 150e of combiner/divider section 180 through an RDL conductive trace 154d. Likewise, metal pillar 150b formed on amplifier chip 122 connects to a metal pillar formed on phase shifter 325 through an RDL conductive trace 154b. Note that while RDL 154 is shown to include a single metal layer in FIG. 4, RDL 154 may include multiple metal layers (separated by isolation layers) in alternative examples.

In other embodiments, RDL 154 has electrical contacts that are connected directly to electrical contacts (not shown) of amplifier chip 122 at its upper surface 121. In this case, the upper metal pillars 150a, 150b, etc. may be omitted and the thickness of the molding material 126 atop amplifier chip 122 may be reduced or the molding material atop amplifier chip 122 is omitted.

Other conductive traces of RDL 154 are "fan out" conductive traces such as 154a and 154c that connect metal pillars 150 to larger solder balls 152 located beyond the peripheries of the respective chips 122, 325. A solder ball 152 may have a diameter in the range of .075 to 1.8mm whereas a metal pillar 150 may have a largest cross-sectional dimension (in the xy plane) in the range of 10 - 150um. Amplifier chip 122 may have a parallelepiped geometry, with a surface area (in the xy plane) in the range of 0.25mm² to 25mm² and a largest cross-sectional dimension (in the xy plane) in the range of 0.5mm to 5mm. Phase shifter chip 325 may have similar cross-sectional dimensions (but may be made substantially thinner as discussed below). Because solder balls 152 are large relative to the surface areas of upper surface 121 of amplifier chip 122 and that of the upper surface of phase shifter chip 325, the fan out traces 154a, 154c, etc. facilitate / make possible connections from each chip 122, 325 to multiple solder balls 152. Solder balls 152 may connect to PWB 130 via contact pads 132, which in turn connect to signal lines such as 133 and 137 within PWB 130. Control circuitry 135, e.g., an FGPA, may provide control signals and/or DC biasing voltages to amplifier chip 122 and phase shifter chip 325 through signal lines 137 and 133, respectively.

FIG. 5A is a cross-sectional view of a portion of antenna apparatus 100, depicting another example internal structure, including radiation shielding. The structure of FIG. 5A differs from that of FIG. 4 by substituting a thinned phase shifter chip 325' for phase shifter chip 325, and by including a radiation shield 505 between phase shifter chip 325' and antenna substrate 110. (Note that in other examples, a radiation shield such as 505 is provided between the antenna substrate and other types of RFIC chips.) In space-based applications and other potential applications, radiation R may be harmful to silicon-based or other RFIC chips and reduce their lifetime. Such radiation R may be in the form of ionizing radiation, wave radiation, particle radiation, solar radiation, cosmic background radiation and/or electromagnetic radiation. Shielding sufficient to protect against these types of radiation may be provided through deployment of radiation shield 505 composed of a thick, dense material, e.g., a pure metal such as copper, tungsten, tantalum or platinum, or a metal alloy. In other embodiments, radiation shield 505 is composed of a mixture of metal and dielectric materials. In one embodiment, radiation shield 505 is at least 50µm thick (thickness is in the z direction). In another embodiment, radiation shield 505 is at least 100µm thick. Radiation shield 505 is coextensive with phase shifter chip 325' in the xy plane in some embodiments. In other embodiments, radiation shield 505 has a larger or smaller profile than phase shifter chip 325' in the xy plane.

As illustrated in FIG. 5A, although phase shifter chip 325' is considerably thinner than each of phase shifter chip 325 and amplifier chip 122 (e.g., at least half as thin), it is desirable for its upper surface to be coplanar with upper surface 121 of amplifier chip 122 and the upper surface of combiner/divider section 180. This facilitates connections to the adjacent components 122, 180 using uniform metal pillars 150 formed on the upper surfaces of each. Radiation shield 505 may be adhered to antenna substrate 110 by adhesive 405. Phase shifter chip 325' may be directly adhered to radiation shield 505 by an adherent 507. Alternatively, a thin layer of molding material 126 (not shown) separates phase shifter chip 325' and radiation shield 505, and phase shifter chip 325' is adhered to the molding material 126 by an adhesive.

FIG. 5B is a cross-sectional view of a portion of antenna apparatus 100, depicting another example internal structure including a thicker radiation shield, 505'. In this embodiment, the upper surface of radiation shield 505' may extend beyond the upper surface 121 of amplifier chip 122 (e.g., it is coplanar with the upper surface 426 of molding material 126), and/or a phase shifter chip 325" is provided which is thicker than phase shifter chip 325' of FIG. 5A . (Phase shifter chip 325" may also be thicker than amplifier chip 122 in some embodiments.) Thus, to connect a metal pillar on upper surface 121 of amplifier chip 122 to an electrical contact of phase shifter chip 325", metal pillars 150 may be formed on the lower surface of phase shifter chip 325", rather than on its upper surface. A redistribution layer (RDL) 560 is therefore disposed between the upper surface of radiation shield 505' and the lower surface of phase shifter chip 325". Solder caps 157 on upper surfaces of the metal pillars 150 between phase shifter chip 325" and RDL 560 may be included to facilitate electrical and mechanical connection therebetween. In alternative examples, some or all of these metal pillars such as 150p are replaced by solder balls, or, standard pins that are mounted with a solder paste. In FIG. 5B, RDL 560 is exemplified as a multi-layer RDL, e.g., with three metal layers 554, 566 and 568, separated from one another by dielectric material 576. In other examples, RDL 576 has one or two layers. Another layer of molding or underfill material, 526, may surround the metal pillars 150 at the lower surface of phase shifter chip 325". Material 526 may also surround at least a portion of the periphery of phase shifter chip 325" and partially encapsulate the same. During fabrication of antenna apparatus 100, material 526 may be applied after phase shifter chip 325" is attached to RDL 560.

For example, a metal pillar 150k atop amplifier chip 122 connects to a metal pillar 150m formed on the lower surface of phase shifter chip 325" through a fan out conductive trace 564a of layer 564. The connection between trace 564a to metal pillar 150m may be through vias formed between layers 564, 566 and 568 in this example. FGPA chip 135 may provide bias / control signals to amplifier chip 122 through signal 137, an electrical contact 132, a solder ball 152, RDL 560, and a metal pillar 150 on amplifier chip 122's upper surface. FGPA chip 135 may provide control signals to phase shifter chip 325" through path 133 in the same way through another solder ball 152 (not shown, e.g., spaced from chip 325" in the y direction) and a metal pillar 150 on the lower surface of phase shifter chip 325".

FIG. 5B also illustrates that an intermediate amplifier chip 530 may be included within antenna apparatus 100, adjacent to phase shifter chip 325". Amplifier chip 530 may be adhered to antenna substrate 110 through a suitable adherent 535 similar to adherent 405. Amplifier chip 530, like amplifier chip 122, may be at least partially encapsulated by molding material 126 and may have an upper surface 521 with a central region (with an active region directly behind the upper surface 521) that interfaces with air instead of the molding material, for better thermal dissipation. The active region of amplifier chip 530 may be just below its upper surface 521. FGPA chip 135 may provide bias / control signals to amplifier chip 535 through signal path 937, a solder ball 152, RDL 560, etc., in the same way as described for amplifier chip 122. As mentioned earlier in connection with FIGS. 2 - 3B, a receive path intermediate amplifier within amplifier chip 530 may amplify a partially combined receive signal (e.g., a signal at signal line 139 of FIG. 2) derived from antenna element signals received from plural antenna elements 140 and LNAs 142. Likewise, a transmit path intermediate amplifier within chip 530 may amplify a partially divided transmit signal appearing, e.g., at signal line 139. A metal pillar such as 150j may route an RF signal to/from amplifier chip 530 and phase shifter chip 325" through RDL 560 and a metal pillar such as 150p.

In embodiments in which solder balls 152 may not provide enough vertical (z direction) separation between PWB 130 and BFN 120 due to the thicker radiation shield 505' and/or a thicker RDL 560, solder balls 152 may be substituted with electrically conductive columns having a longer vertical dimension. The columns may be flexible and configured with shapes such as a solid cylinder; a solid cylinder with a spiraling skin of a different material; a spring; a flexible solid structure; or a micro-coaxial cable section. The columns may be composed of solder (e.g. a Pb / Sn alloy) or other conductive material. In one example, the columns are column grid array (CGA) type columns with a Pb / Sn alloy interior cylinder and a spiraling wrapped skin made of copper for better heat conduction and reliability.

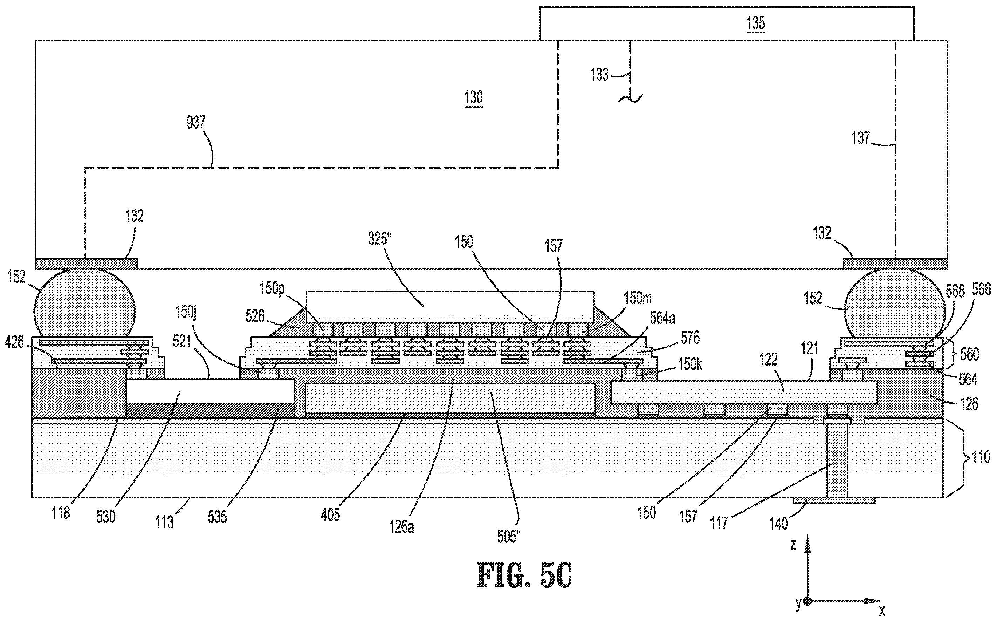

FIG. 5C is another example cross-sectional view of a portion of antenna apparatus 100, depicting still another example internal structure. In this example, a radiation shield 505" is provided which may be thicker than radiation shield 505 of FIG. 5A, and may or may not have an upper surface that extends beyond the upper surface 121 of amplifier chip 122. The structure differs from that of FIG. 5B by providing a thin molding material layer 126a of molding material 126 between the upper surface of radiation shield 505" and the lower surface of RDL 560. Thus, radiation shield 505" is further encapsulated (embedded) by molding material 126. Because the upper surface of molding material layer 126a may be formed flatter than that of radiation shield 505", e.g., through a planarization process, the flatter surface may facilitate a subsequent formation of the portion of RDL 560 upon layer 126a.

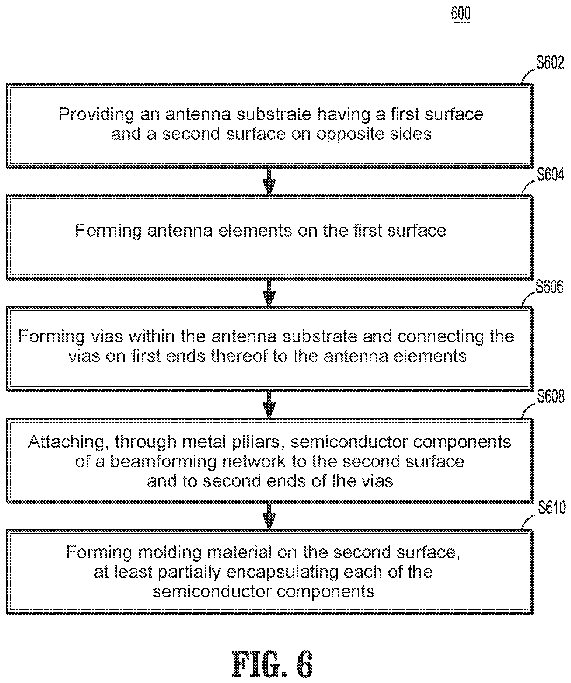

FIG. 6 is a flow diagram of a general example method, 600, for fabricating an antenna apparatus according to an embodiment. The order of the individual steps shown of FIG. 6 may be rearranged as desired, and/or individual steps may be combined as part of the same process step, if possible. An antenna substrate having first and second surfaces on opposite sides is provided (process step S602). The first surface may be dielectric and the second surface may be metal of an antenna ground plane, which forms part of the antenna substrate. Alternatively, the first surface is a dielectric surface of a multilayer region serving as a signal routing region. The signal routing region may include two or more thin metal layers and two or more thin dielectric isolation layers, where one isolation layer separates the metal layers and the other isolation layer forms an outer (upper) surface of the antenna substrate. One of the metal layers may serve as both an antenna ground plane and as ground connection for the signals, while the other metal layer may be used to form conductive traces for signals.

Antenna elements are formed on the first surface (S604), e.g., by printing patch elements or dipoles. Vias are formed within the antenna substrate and connected on first ends thereof to the antenna elements (S606) to form probe feeds. Semiconductor components, e.g., amplifier chips 122 of a BFN 120, are attached through metal pillars to the second surface and to second ends of the vias (S608). Molding material is formed on the second surface, at least partially encapsulating each of the semiconductor components (S610). Thereafter, the assembly may be attached to a PWB configured to provide control signals and bias voltages to the semiconductor components.

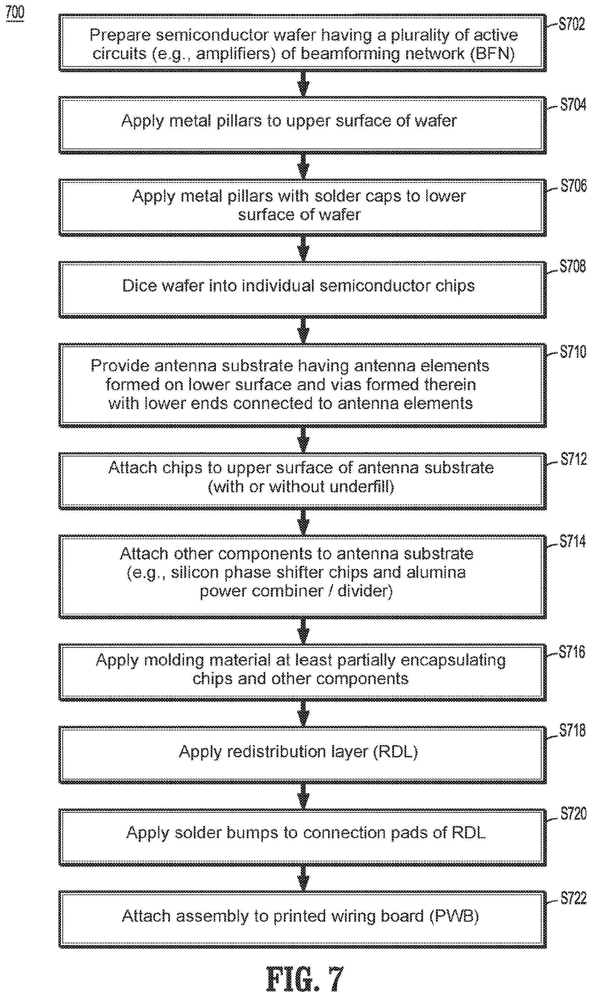

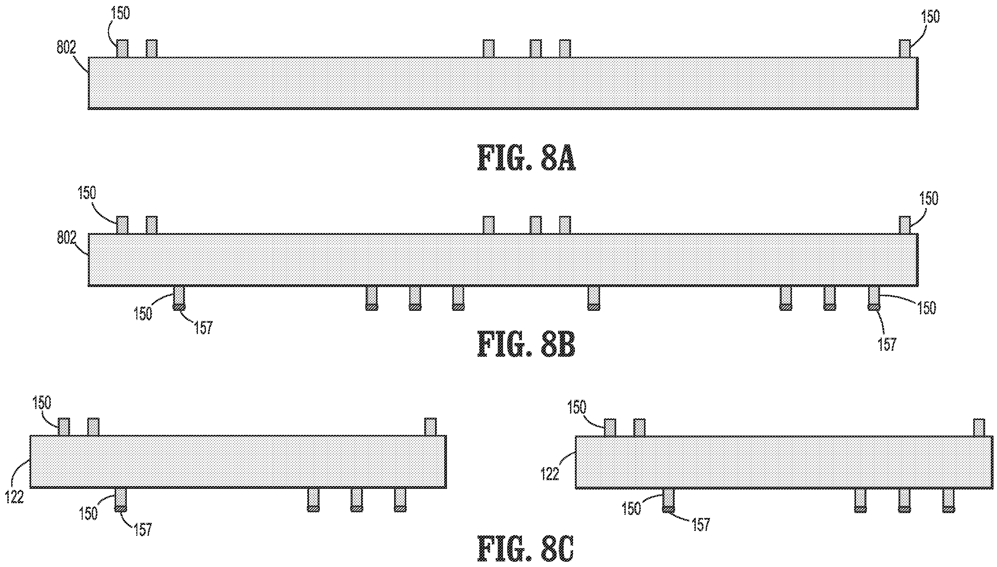

FIG. 7 is a flow diagram of an example method, 700, of fabricating an antenna apparatus having structures illustrated in FIGS. 4 or 5 according to an embodiment. Method 700 will be discussed below with reference to FIGS. 8A - 8I, which are cross-sectional views illustrating respective steps in method 700.

A semiconductor wafer having a plurality of active circuits (e.g., amplifiers) of a BFN is prepared (process step S702). Metal pillars may be applied to an upper surface of the wafer using a standard metal pillar build-up process (S704). For instance, as shown in FIG. 8A, metal pillars 150 are formed on an upper surface of semiconductor wafer 802, where the upper portion of wafer 802 may be an active region containing the active circuits. As mentioned earlier, metal pillars 150 may be copper pillars, gold pillars, platinum pillars or mixed alloy pillars, and may have small dimensions in the ranges noted above.

Metal pillars 150 with solder caps 157 may be applied to a lower surface of the wafer 802, as illustrated in FIG. 8B (S706). The solder caps may be applied to lower ends of the metal pillars after the metal pillars are built up on the lower wafer surface. The wafer may then be diced into individual semiconductor chips 122 as shown in FIG. 8C (S708).

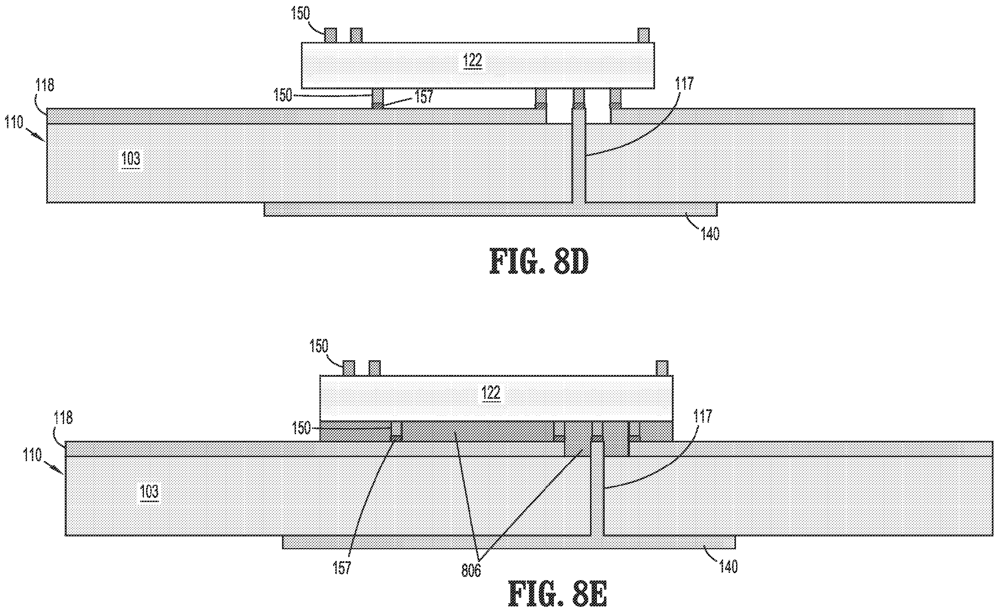

As shown in FIG. 8D, an antenna substrate 110 may be provided (S710). The antenna substrate 110 may have a lower portion 103 composed of dielectric material; an antenna ground plane 118 formed on the lower portion 103 and forming at least part of an upper surface of the antenna substrate; and vias 117 formed between the upper surface and a lower surface. Antenna elements 140 may be formed on the lower surface, each connected to one or more vias 117. Note that in some embodiments, antenna element modules may be formed individually and assembled to chips 122 by dicing sections of antenna substrate 110 after antenna elements 140 are formed, where each module includes one or more antenna elements 140. The dicing into modules could alternatively be done after chips 122 are assembled to a pre-diced antenna substrate 110.

The semiconductor chips 122 with metal pillars already formed on opposite surfaces may be attached to the upper surface of the antenna substrate, with or without underfill, as shown in FIG. 8D and alternatively in FIG. 8E (S712). FIG. 8D shows a semiconductor chip 122 attached without underfill, and FIG. 8E shows a semiconductor chip 122 attached with underfill 806. Underfill 806 may be applied before or after attachment of chip 122 to antenna substrate 110. As seen in FIG. 8E, the underfill 806 may also be applied to fill the annular region surrounding the upper end of via 117 and adjacent edges of ground plane 118.

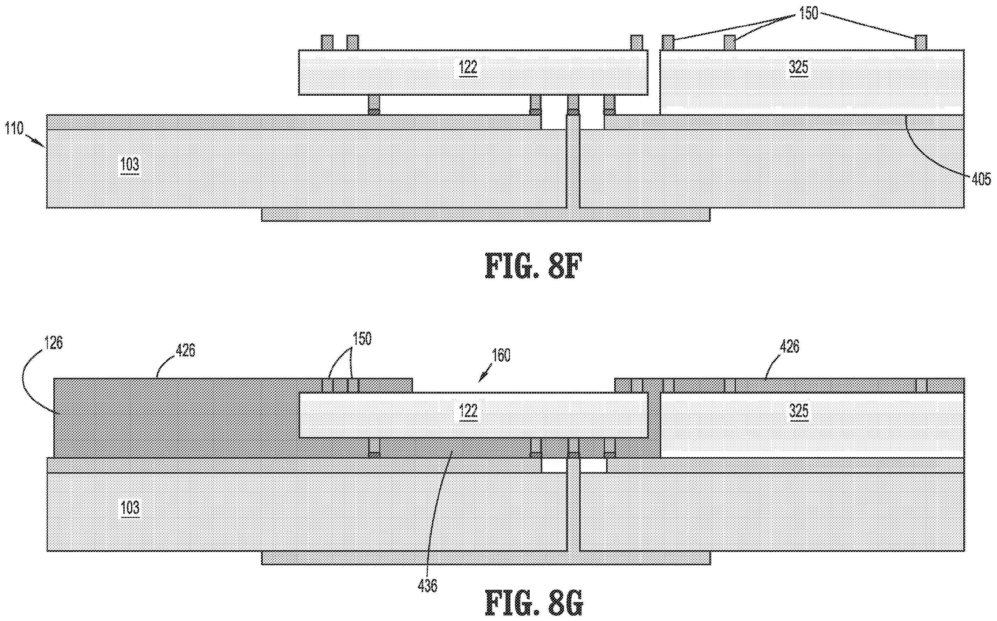

Other BFN components, such as silicon phase shifter chips 325, combiner/divider sections 180, and intermediate amplifiers 530, may be attached to the antenna substrate 110 as shown in FIG. 8F (S714). These BFN components may have had metal pillars 150 already formed on upper surfaces thereof prior to the attachment to antenna substrate 110. For instance, multiple phase shifter circuits may have been originally formed on a silicon wafer and diced into individual chips 325, akin to the formation of semiconductor chips 122 as in FIGS. 8B and 8C (without metal pillars formed on the lower surface of the silicon wafer). Silicon chips 325 and combiner/divider sections 180 (not shown in FIG. 8F) may be attached to antenna substrate 110 by an adherent 405, e.g., a solder cap or an adhesive. In embodiments employing a radiation shield 505, 505' or 505" as in FIGS. 5A-5C, the radiation shield 505, 505' or 505" may be adhered to antenna substrate 110 or 110' prior to adhering silicon chip 325' to the radiation shield, or, in the embodiments of FIGS. 5B-5C, prior to attaching phase shifter chips 325" to the RDL layer 560 formed above the radiation shield 505' or 505".

As shown in FIG. 8G, molding material 126 may be applied to at least partially encapsulate semiconductor chips 122 and the other components, e.g., 325, 325', 505, 505', 505", 180 (S716). In this process step, the molding material 126 may be initially applied in a non-cured state (liquid or pliable) and then cured. Once cured, it may extend above the upper metal pillars 150. It may thereafter be trimmed / planarized to form an upper surface 426 coplanar with the upper surfaces of the upper metal pillars 150. In embodiments where underfill 806 is not applied, as in FIG. 8D, the molding material 126 may be applied in a manner sufficient to fill the regions 436 directly beneath semiconductor chips 122. During the molding material application step, the air gap above the central portion 160 of semiconductor chip 122 may be formed. For instance, there may be a sacrificial layer deposition step on the central portion 160 prior to applying the molding material 136. In this case, after the molding material is applied and trimmed / planarized, the sacrificial layer may be removed mechanically or chemically. Alternatively, the central portion 160 of the semiconductor chip is masked prior to applying the molding and the mask is removed once the molding is applied.

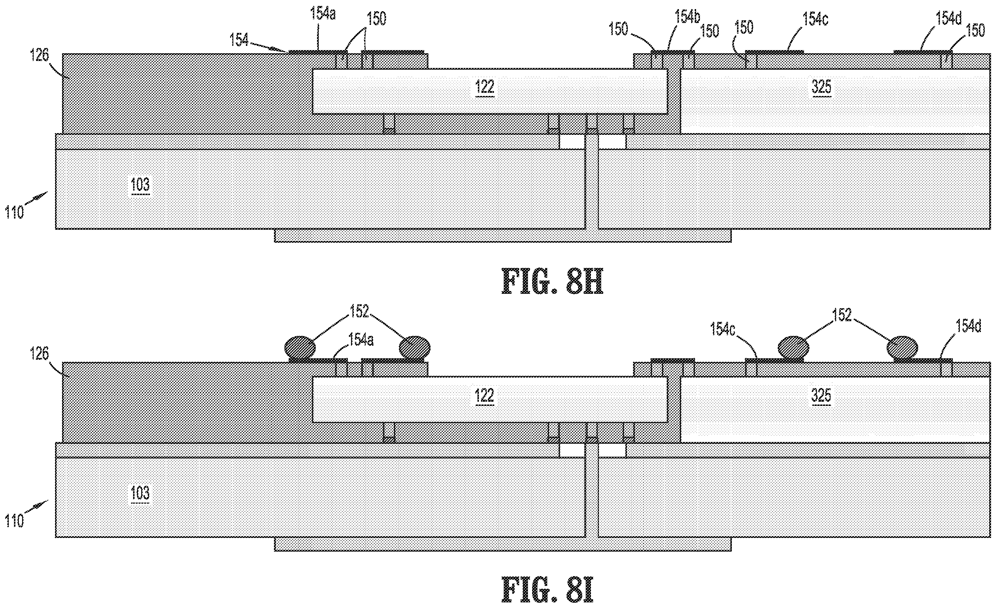

As depicted in FIG. 8H, a redistribution layer (RDL) 154 (or 560) may be applied to form individual conductive traces / connection pads such as 154a to 154d electrically connected to respective upper metal pillars 150 (S718). As mentioned earlier, RDL 154 may be formed with multiple metal layers (e.g., as RDL 560) if desired, in which case metal layers and isolation layers of a multi-layer RDL may be alternately formed by alternating metal layer deposition and isolation layer deposition processes.

As shown in FIG. 8I, solder balls may be selectively applied to the conductive traces of RDL 154 (S722). In addition, during this time, in the embodiments of FIGS. 5B and 5C, phase shifter chips 325" may be attached to RDL 560, and material 526 may be applied to partially encapsulate the phase shifter chips 325". PWB 130 may then be attached to the interim assembly of FIG. 8I to finally assemble antenna apparatus 100 as illustrated in FIGS. 4, 5A, 5B or 5C.

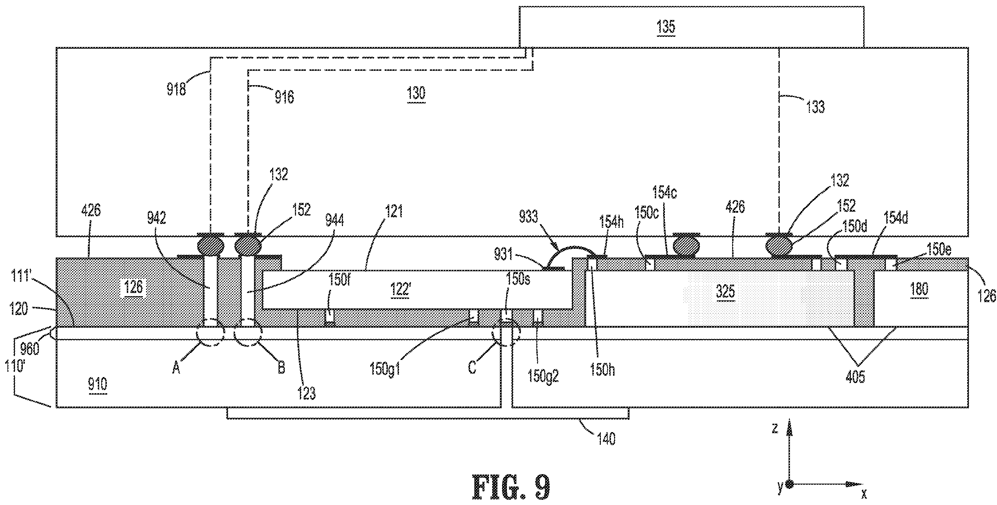

FIG. 9 is a cross-sectional view of a portion of the antenna apparatus of FIG. 1, depicting still another example internal structure. The structure of FIG. 9 differs from that of FIGS. 4 and 5 by omitting the metal pillars on the upper surface of amplifier chip 122. Instead of supplying bias voltages and control signals from FPGA 135 to an amplifier chip 122' at the top surface, connections may instead be made to contact points at the bottom surface of amplifier chip 122' through vias within molding material 126 and a multilayer RDL region 960 at the upper portion of the antenna substrate. Additionally, RF signal connections between amplifier chip 122' and phase shifter chip 325 may be made through wire-bonds at the upper surfaces of each component. Amplifier chip 122' may differ slightly from amplifier chip 122 by including vias (not shown) extending from the lower surface 123 to the active region at the upper portion of the chip to route the control / DC signals from FPGA 135 to the active region transistors.

Accordingly, the structure of FIG. 9 includes "through-mold vias" such as 942 and 944 extending through molding material 126; a modified antenna substrate 110' including an upper portion with multilayer RDL region 960 and a lower portion with dielectric 910; and wirebonds such as 933 electrically connecting an upper surface contact 931 atop upper surface 121 of amplifier chip 122' to an RDL contact pad 154h atop metal pillar 150h of phase shifter chip 325. In an example, FGPA 135 may supply a control / DC bias signal to amplifier chip 122' by supplying a signal level voltage to via 942 via signal path 918 within PWA 130, a contact pad 132 and a solder ball 152 attached to PWA 130; and supplying a ground level voltage to via 944 via signal path 916 within PWA 130, or vice versa. The signal level and ground level voltages may be routed within region 960 to respective signal and ground contacts at the lower surface 123 of amplifier chip 122'. FGPA 135 is also shown to route control signals to phase shifter chip 325 through contacts at the upper surface of phase shifter 325 in the same manner as in FIGS. 4 and 5. In an alternative embodiment, these signals are routed through additional mold-through vias (not shown) within molding material 126 and through RDL region 960 to contacts at a lower surface of phase shifter chip 325 in a similar manner as for amplifier chip 122'.

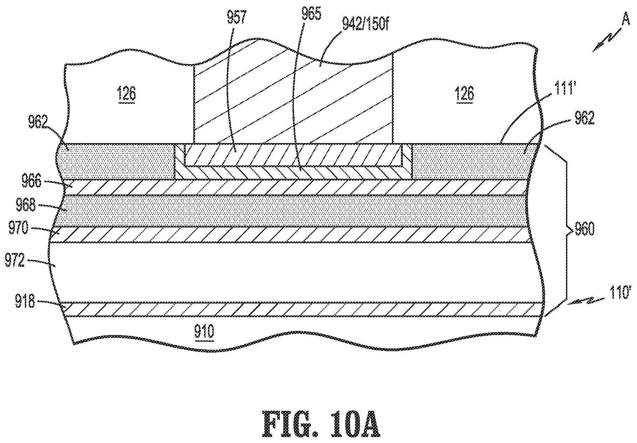

FIG. 10A illustrates an example interconnect structure of the region "A" in FIG. 9. RDL region 960 may include, in order from the upper surface 111' to the lower dielectric region 910, a first isolation layer 962, a first metal layer 966, a second isolation layer 968, a second metal layer 970, a third isolation layer 972, and a third metal layer 918. The connection structure of FIG. 10A illustrates a connection between via 942 to first metal layer 966 to route a signal level voltage or a ground level voltage of a control / DC bias signal from FPGA 135. The same connection structure may be used to connect a signal / ground line within amplifier chip 122' to metal layer 966 through a metal pillar such as 150f, to receive the voltage on metal layer 966.

In other embodiments, more or fewer isolation / metal layers are included in RDL region 960. For example, in the case of FIG. 10A, in some embodiments the third metal layer 918 is used for the antenna ground plane. In other examples, layer 918 is omitted and the layer 970 is used for both the antenna ground plane and for receiving and routing a ground voltage. In still another example, layer 918 is used as a coplanar or microstrip transmission line to route RF signals, and another layer (not shown) below layer 918 is employed for the antenna ground plane.

First isolation layer 962 may be a polymer, e.g., Benzocyclobutene (BCB), the top surface of which forms the top surface 111' of antenna substrate 110'. First metal layer 966 ("first conductive trace layer") may be designated for forming signal conductors for DC and / or control signals, or for forming ground conductors for the DC / control signals. When first metal layer 966 is designated for the ground conductors, second metal layer may be designated for forming the signal conductors for these signals, and vice versa. It is also feasible to use a single layer 966 or 970 for both signal and ground conductors. In the example of FIG. 10A, via 942 is electrically connected to first layer metal 966 through an opening in isolation layer 962 slightly larger than the diameter of via 942 (or metal pillar 150f). To facilitate formation of an electrical connection joint, a surface finish metal layer 965 such as Electroless Palladium Immersion Gold (ENEPIG) or a nickel/gold alloy may have been formed within the opening in isolation layer 962. Layer 965 may have been deposited to have a base portion atop metal layer 966, a peripheral wall portion around the periphery of the opening, and an annular ring region at the upper surface 111', to form a cavity. A well of solder or other liquefiable metal 957 (e.g., solder cap 157 in the case of the lower metal pillar 150f connection) may fill the cavity, adhering to both the surface finish layer 965 and the lower end of via 942 / metal pillar 150f. This forms the mechanical connection between the via / metal pillar and antenna substrate 110' and the electrical connection to metal layer 966 therein. Note that in other embodiments, surface finish metal layer 965 is omitted. In other embodiments, via 942 connects directly to metal layer 966, such that the separate solder 957 and surface finish metal layer 965 are omitted. In this case, via 942 may be formed by drilling and metal deposition, etc., after BFN 120 is adhered to antenna substrate 110'.

Each of metal layers 960 and 970 and isolation layers 962 and 968 may be at least one order of magnitude thinner than the thickness of substrate 110'. For instance, each of these layers may have a thickness on the order of 2-10 µm whereas the thickness of substrate 110' may be on the order of 250 µm. Metal layers 966 and 970 may each form signal / ground lines in the x-y plane having a width on the order of 12 µm and spaced from one another by a spacing on the order of 12 µm. Each of layers 966 and 970 may have been etched or otherwise patterned to form tens, hundreds or thousands of signal lines and ground lines in various embodiments of antenna 100.

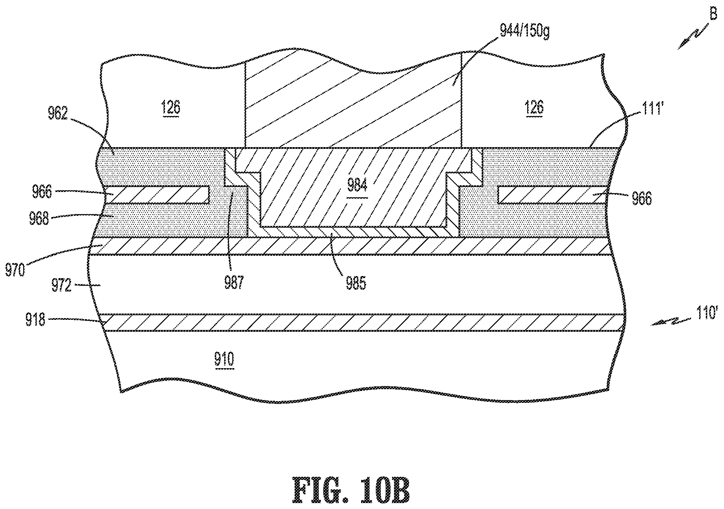

FIG. 10B illustrates an example interconnect structure of the region "B" in FIG. 9. In this example, via 944 is electrically connected to second metal layer 970; the same construction may be used to electrically connect metal pillar 150g1, 150g2 or 150f (or any other lower metal pillar 150 between amplifier chip 122 and substrate 111') to second metal layer 970. Via 944, discussed as an example hereafter, is connected through openings in first isolation layer 962, first metal layer 966 and second isolation layer 968. The openings in these layers may have been formed by aligning resist material with different geometries layer by layer during deposition of the respective layers. To prevent via 944 from shorting to first metal layer 966, first metal layer 966 may have been formed by deposition patterning with a larger opening than those of first and second isolation layers 968 and 962. An annular isolation region 987 may have been formed at the depth of metal layer 966 to isolate metal layer 966 from a subsequent electrical connection between via 944 and second metal layer 970. A surface finish layer 985 akin to surface finish layer 965 of FIG. 10A may have been formed using electroplating or the like. Surface finish layer 985 may have a base portion on second metal layer 970; annular wall portions against the edges of isolation layers 962, 966 and 968 in the respective openings; and a rim portion on upper surface 111'. This results in a metal-lined cavity which can be filled with solder or other liquefiable metal 984 (e.g., solder cap 157). When the solder 984 cools while the lower end of via 944 is placed adjacent to or slightly penetrating the cavity, the solder 984 electrically connects via 944 to second layer 970 through surface finish layer 985. (Via 944 may slightly penetrate the cavity if formed to slightly protrude from the lower surface of molding material 126.) In other embodiments, surface finish layer 985 is omitted. In other embodiments, via 944 connects directly to metal layer 970. In this case, via 944 may be formed by drilling and metal deposition, etc., after BFN 120 is adhered to antenna substrate 110'.

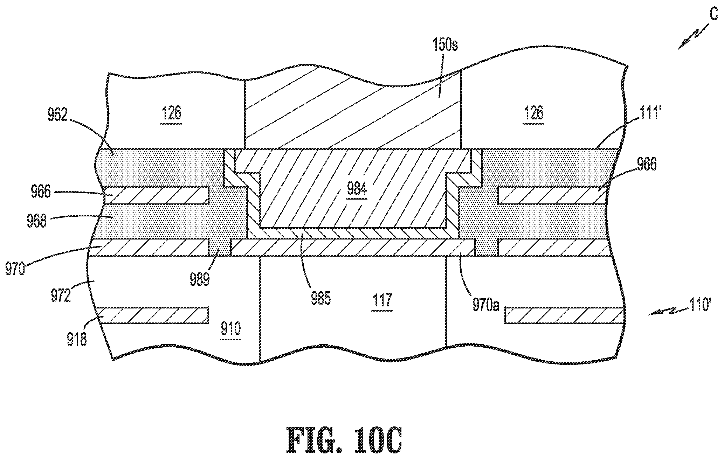

FIG. 10C illustrates an example interconnect structure of the region "C" in FIG. 9, in which "signal metal pillar" 150s is conductively adhered to via 117 within antenna substrate 110'. Via 117 may connect on its upper end to a discshaped catch pad 970a formed within metal layer 970. For instance, metal layer 970 may have been formed atop dielectric layer 910 (in the region above metal layer 972) prior to forming via 117. When forming metal layer 970, catch pad 970a may have been formed by concentrically aligning a ring-shaped resist material with a circular region of via 117 (to be formed subsequently). Metal layer 970 may have then been deposited, resulting in a ring-shaped opening around catch pad 970a. Via 117 may have next been formed through catch pad 970a. Isolation material may have been deposited in a subsequent step to form an annular isolation region 989 within the openings around catch pad 970a, thereby isolating the remaining material of metal layer 970 from via 117. An interconnect structure between catch pad 970a and the lower end of metal pillar 150s may be the same as that described in connection with FIG. 10B for the connection to via 944. That is, the interconnect structure may comprise surface metal layer 985 with a base portion atop catch pad 970a and annular wall portions and a rim portion, forming a cavity which is filled with liquifiable metal 984 as described above.

Antenna apparatus 100 with an internal structure throughout as in FIG. 9 may be formed in a similar manner as the method of FIG. 7, with several variations. These variations may include: (i) omitting the formation of upper metal pillars 150 atop amplifier chips 122; (ii) forming contact pads 931 on the upper surface 121 of amplifier chip 122 and connecting the same to corresponding RDL conductive traces 154 on adjacent components with wire bonds; (iii) forming the "through-mold vias" such as 942 and 944 within molding material 126 after the latter has cured; (iv) providing antenna substrate 110' with multi-layered region 960 rather than just ground plane 118; and (v) making suitable connections between lower ends of the through-mold vias and the lower metal pillars to the metal layers within region 960 as described above.

Embodiments of an antenna apparatus as described above may be formed with a low profile and may therefore be particularly advantageous in constrained space applications. Further, the construction is amenable for including low loss elements, e.g., low loss transmission lines and antenna substrates, which may be particularly beneficial at millimeter wave frequencies. Moreover, methods of forming antenna apparatus herein may omit certain process steps of related art methods, resulting in more cost efficient manufacturing.

While the technology described herein has been particularly shown and described with reference to example embodiments thereof, it will be understood by those of ordinary skill in the art that various changes in form and details may be made therein without departing from the scope of the claimed subject matter as defined by the following claims.

## Claims

1. An antenna apparatus (100) comprising:
an antenna substrate (110) having a first surface (113) and a second surface (111) on opposite sides;
a plurality of antenna elements (140) formed on the first surface;
a plurality of vias within the antenna substrate
a beamforming network (120) including a plurality of semiconductor components (122, 122', 172, 325, 530), each having a third surface (123) facing the antenna substrate;
metal pillars (150) attaching the second surface to the third surface to thereby attach the semiconductor components to the antenna substrate, wherein the semiconductor components are radio frequency, RF, coupled to the plurality of antenna elements through the vias; and
molding material (126) is formed on the second surface and is at least partially encapsulating each of the plurality of semiconductor components.

2. The antenna apparatus (100) of claim 1, wherein the molding material is disposed on side surfaces (128) of each of the plurality of semiconductor components perpendicular to the third surface, and on at least a portion of a fourth surface (121) of each of the semiconductor components opposite the third surface.

3. The antenna apparatus (100) of claim 2, further comprising a redistribution layer (154) formed on the molding material and spaced from the fourth surface by a thickness of a portion of the molding material that is disposed on the fourth surface.

4. The antenna apparatus (100) of claim 2, wherein:
the molding material formed on at least a portion of the fourth surface is formed on a first portion of the fourth surface;
a second portion of the fourth surface (160) interfaces with air; and
each of the plurality of semiconductor components includes active circuitry (402) directly behind the second portion of the fourth surface, and optionally wherein the first portion of the fourth surface is a peripheral portion of the fourth surface, and the second portion of the fourth surface that interfaces with air is a central portion of the fourth surface.

5. The antenna apparatus (100) of claim 2, wherein:
the antenna apparatus further comprises metal pillars (150a, 150b) formed on the fourth surface of each of the plurality of semiconductor components to form electrical connections, wherein the molding material surrounds the metal pillars on the fourth surface; or
the molding material is further disposed between the third surface of each of the semiconductor components and the second surface of the antenna substrate; or
the antenna apparatus further comprises underfill material, different from the molding material, in a region (436) between the second surface of the antenna substrate and the third surface of each of the plurality of semiconductor components.

6. The antenna apparatus (100) of claim 1, wherein the antenna substrate includes a ground plane (118) that is behind the second surface and/or forms at least a portion of the second surface, the ground plane including a plurality of openings (412) through which the plurality of semiconductor components are coupled to the plurality of antenna elements through the vias.

7. The antenna apparatus (100) of claim 1, wherein the plurality of semiconductor components are a plurality of radio frequency integrated circuit, RFIC, chips (122, 122', 530, 172, 325, 325', 325") each including at least one amplifier and/or at least one phase shifter.

8. The antenna apparatus (100) of claim 7, wherein:
the plurality of RFIC chips include amplifier chips (122, 122', 530) each comprising a first semiconductor material, and phase shifter chips (172, 325, 325', 325") each comprising a second, different semiconductor material and each coupled to at least one of the amplifier chips; or
the antenna apparatus further comprises a metal pillar (150b) formed on a fourth surface (121) opposite the third surface of a first one of the RFIC chips (122), coupled to a metal pillar formed on a fourth surface opposite the third surface of a second one of the RFIC chips (325), through a redistribution layer (154b) formed on a surface (426) of the molding material formed on the fourth surfaces of the first and second ones of the RFIC chips.

9. The antenna apparatus (100) of claim 7, further comprising a radiation shield (505, 505') between a said RFIC chip and the second surface of the antenna substrate, and optionally wherein the radiation shield (505, 505') is composed of at least one of tungsten and tantalum.

10. The antenna apparatus (100) of claim 7, further comprising:
a radiation shield (505') between a said RFIC chip and the second surface of the antenna substrate; and
a redistribution layer, RDL, (560) between the radiation shield and the RFIC chip, and optionally further comprising:
further metal pillars (150m, 150p) between the RDL and a lower surface of the RFIC chip, and coupled to another one of the RFIC chips through the RDL, optionally wherein the RDL includes fan out conductive traces from each of the plurality of semiconductor components.

11. The antenna apparatus (100) of claim 7, further comprising:
a radiation shield (505") between a said RFIC chip and the second surface of the antenna substrate;
a redistribution layer, RDL, (560) between the radiation shield and the RFIC chip;
and
further molding material (126a) between the radiation shield and the RDL.

12. The antenna apparatus (100) of claim 1, wherein:
the plurality of semiconductor components each includes a fourth surface on a side opposite the third surface; and
the antenna apparatus further comprising a printed wiring board, PWB (130), that provides control signals and/or bias voltages to the semiconductor components through a redistribution layer, RDL (154) formed on the molding material coupled to a metal pillar formed on the fourth surface of each of the semiconductor components.

13. The antenna apparatus (100) of claim 1, further comprising a printed wiring board, PWB (130) and wherein the beamforming network further comprises a combiner/divider section (180) at least partially encapsulated by the molding material between the second surface of the antenna substrate and the PWB.

14. The antenna apparatus (100) of claim 1, wherein:
the antenna substrate includes a redistribution layer, RDL, region (960) proximate the second surface, for routing control signals and/or bias voltages to the plurality of semiconductor components (122'); and
the antenna apparatus further comprising a printed wiring board, PWB (130) that provides the control signals and/or bias voltages to the semiconductor components through the RDL region and vias (942, 944), within the molding material, connected to the RDL region.

15. The antenna apparatus (100) of claim 14, further comprising a wirebond (933) attached to an electrical contact (931) on a fourth surface (121) of a first one of the semiconductor components (122') opposite the third surface, the wirebond coupling the first one of the semiconductor components to a second one of the semiconductor components (325).

## Patentansprüche

1. Antenneneinrichtung (100), die Folgendes umfasst:
ein Antennensubstrat (110) mit einer ersten Oberfläche (113) und einer zweiten Oberfläche (111) auf gegenüberliegenden Seiten;
mehrere Antennenelemente (140), die auf der ersten Oberfläche gebildet sind;
mehrere Vias innerhalb des Antennensubstrats;
ein Strahlformungsnetzwerk (120), das mehrere Halbleiterkomponenten (122, 122', 172, 325, 530) beinhaltet, die jeweils eine dritte Oberfläche (123) aufweisen, die dem Antennensubstrat zugewandt ist;
Metallsäulen (150), die die zweite Oberfläche an der dritten Oberfläche befestigen, um dadurch die Halbleiterkomponenten an dem Antennensubstrat zu befestigen, wobei die Halbleiterkomponenten durch die Vias mit den mehreren Antennenelementen hochfrequenz- bzw. HF-gekoppelt sind; und
ein Vergussmaterial (126) auf der zweiten Oberfläche gebildet ist und jede der mehreren Halbleiterkomponenten wenigstens teilweise verkapselt.

2. Antenneneinrichtung (100) nach Anspruch 1, wobei das Vergussmaterial auf Seitenoberflächen (128) jeder der mehreren Halbleiterkomponenten senkrecht zu der dritten Oberfläche und auf wenigstens einem Teil einer vierten Oberfläche (121) jeder der Halbleiterkomponenten gegenüber der dritten Oberfläche angeordnet ist.

3. Antenneneinrichtung (100) nach Anspruch 2, die ferner eine Umverteilungsschicht (154) umfasst, die auf dem Vergussmaterial gebildet ist und von der vierten Oberfläche durch eine Dicke eines Teils des Vergussmaterials beabstandet ist, das auf der vierten Oberfläche angeordnet ist.

4. Antenneneinrichtung (100) nach Anspruch 2, wobei:
das Vergussmaterial, das auf wenigstens einem Teil der vierten Oberfläche gebildet ist, auf einem ersten Teil der vierten Oberfläche gebildet ist;
ein zweiter Teil der vierten Oberfläche (160) an Luft angrenzt; und
jede der mehreren Halbleiterkomponenten eine aktive Schaltungsanordnung (402) direkt hinter dem zweiten Teil der vierten Oberfläche beinhaltet, und wobei optional der erste Teil der vierten Oberfläche ein Peripherieteil der vierten Oberfläche ist und der zweite Teil der vierten Oberfläche, der an Luft grenzt, ein zentraler Teil der vierten Oberfläche ist.

5. Antenneneinrichtung (100) nach Anspruch 2, wobei:
die Antenneneinrichtung ferner Metallsäulen (150a, 150b) umfasst, die auf der vierten Oberfläche jeder der mehreren Halbleiterkomponenten gebildet sind, um elektrische Verbindungen zu bilden, wobei das Vergussmaterial die Metallsäulen auf der vierten Oberfläche umgibt; oder
das Vergussmaterial ferner zwischen der dritten Oberfläche jeder der Halbleiterkomponenten und der zweiten Oberfläche des Antennensubstrats angeordnet ist; oder
die Antenneneinrichtung ferner ein Unterfüllungsmaterial, das sich von dem Vergussmaterial unterscheidet, in einem Gebiet (436) zwischen der zweiten Oberfläche des Antennensubstrats und der dritten Oberfläche jeder der mehreren Halbleiterkomponenten umfasst.

6. Antenneneinrichtung (100) nach Anspruch 1, wobei das Antennensubstrat eine Massefläche (118) beinhaltet, die sich hinter der zweiten Oberfläche befindet und/oder wenigstens einen Teil der zweiten Oberfläche bildet, wobei die Massefläche mehrere Öffnungen (412) beinhaltet, durch die hindurch die mehreren Halbleiterkomponenten mit den mehreren Antennenelementen mittels der Vias gekoppelt sind.

7. Antenneneinrichtung (100) nach Anspruch 1, wobei die mehreren Halbleiterkomponenten mehrere Hochfrequenz-Integrierter-Schaltkreis(RFIC: Radio Frequency Integrated Circuit)-Chips (122, 122', 530, 172, 325, 325', 325") sind, die jeweils wenigstens einen Verstärker und/oder wenigstens einen Phasenschieber beinhalten.

8. Antenneneinrichtung (100) nach Anspruch 7, wobei:
die mehreren RFIC-Chips Verstärkerchips (122, 122', 530), die jeweils ein erstes Halbleitermaterial umfassen, und Phasenschieberchips (172, 325, 325', 325"), die jeweils ein zweites, unterschiedliches Halbleitermaterial umfassen und jeweils mit wenigstens einem der Verstärkerchips gekoppelt sind, beinhalten; oder
die Antenneneinrichtung ferner eine Metallsäule (150b) umfasst, die auf einer vierten Oberfläche (121) gegenüber der dritten Oberfläche eines ersten der RFIC-Chips (122) gebildet ist und die mit einer Metallsäule, die auf einer vierten Oberfläche gegenüber der dritten Oberfläche eines zweiten der RFIC-Chips (325) gebildet ist, durch eine Umverteilungsschicht (154b) gekoppelt ist, die auf einer Oberfläche (426) des Vergussmaterials gebildet ist, das auf den vierten Oberflächen des ersten und zweiten der RFIC-Chips gebildet ist.

9. Antenneneinrichtung (100) nach Anspruch 7, die ferner eine Strahlungsabschirmung (505, 505') zwischen einem besagten RFIC-Chip und der zweiten Oberfläche des Antennensubstrats umfasst, und wobei optional die Strahlungsabschirmung (505, 505') aus Wolfram und/oder Tantal besteht.

10. Antenneneinrichtung (100) nach Anspruch 7, die ferner Folgendes umfasst:
eine Strahlungsabschirmung (505') zwischen einem besagten RFIC-Chip und der zweiten Oberfläche des Antennensubstrats; und
eine Umverteilungsschicht, RDL (Redistribution Layer), (560) zwischen der Strahlungsabschirmung und dem RFIC-Chip, und optional ferner Folgendes umfassend:
weitere Metallsäulen (150m, 150p) zwischen der RDL und einer unteren Oberfläche des RFIC-Chips und durch die RDL mit einem anderen der RFIC-Chips gekoppelt, wobei optional die RDL Fanout-Leiterbahnen von jeder der mehreren Halbleiterkomponenten beinhaltet.

11. Antenneneinrichtung (100) nach Anspruch 7, die ferner Folgendes umfasst:
eine Strahlungsabschirmung (505") zwischen einem besagten RFIC-Chip und der zweiten Oberfläche des Antennensubstrats;
eine Umverteilungsschicht, RDL, (560) zwischen der Strahlungsabschirmung und dem RFIC-Chip; und
weiteres Vergussmaterial (126a) zwischen der Strahlungsabschirmung und der RDL.

12. Antenneneinrichtung (100) nach Anspruch 1, wobei:
die mehreren Halbleiterbauelemente jeweils eine vierte Oberfläche auf einer Seite gegenüber der dritten Oberfläche beinhalten; und
wobei die Antenneneinrichtung ferner eine Leiterplatte, PWB (Printed Wiring Board) (130), umfasst, die Steuersignale und/oder Bias-Spannungen an die Halbleiterkomponenten durch eine Umverteilungsschicht, RDL (154), liefert, die auf dem Vergussmaterial gebildet ist und mit einer Metallsäule gekoppelt ist, die auf der vierten Oberfläche jeder der Halbleiterkomponenten gebildet ist.

13. Antenneneinrichtung (100) nach Anspruch 1, die ferner eine Leiterplatte, PWB (130), umfasst und wobei das Strahlformungsnetzwerk ferner einen Kombinierer/Teilerabschnitt (180) umfasst, der wenigstens teilweise durch das Vergussmaterial zwischen der zweiten Oberfläche des Antennensubstrats und der PWB verkapselt ist.

14. Antenneneinrichtung (100) nach Anspruch 1, wobei:
das Antennensubstrat ein Umverteilungsschicht- bzw. RDL-Gebiet (960) nahe der zweiten Oberfläche zum Routen von Steuersignalen und/oder Bias-Spannungen zu den mehreren Halbleiterkomponenten (122') beinhaltet; und
wobei die Antenneneinrichtung ferner eine Leiterplatte, PWB (130), umfasst, die die Steuersignale und/oder Bias-Spannungen an die Halbleiterkomponenten durch das RDL-Gebiet und Vias (942, 944) innerhalb des Vergussmaterials liefert, die mit dem RDL-Gebiet verbunden sind.

15. Antenneneinrichtung (100) nach Anspruch 14, die ferner eine Drahtbondung (933) umfasst, die an einem elektrischen Kontakt (931) auf einer vierten Oberfläche (121) einer ersten der Halbleiterkomponenten (122') gegenüber der dritten Oberfläche angebracht ist, wobei die Drahtbondung die erste der Halbleiterkomponenten mit einer zweiten der Halbleiterkomponenten (325) koppelt.

## Revendications

1. Dispositif d'antenne (100) comprenant :
un substrat d'antenne (110) présentant une première surface (113) et une deuxième surface (111) sur des côtés opposés ;
une pluralité d'éléments d'antenne (140) formés sur la première surface ;
une pluralité de vias au sein du substrat d'antenne ;
un réseau de formation de faisceaux (120) comportant une pluralité de composants semi-conducteurs (122, 122', 172, 325, 530), présentant chacun une troisième surface (123) en regard du substrat d'antenne ;
des piliers métalliques (150) fixant la deuxième surface à la troisième surface de manière à fixer les composants semi-conducteurs au substrat d'antenne, les composants semi-conducteurs étant couplés en radiofréquence, RF, à la pluralité d'éléments d'antenne à travers les vias ; et
un matériau de moulage (126) étant formé sur la deuxième surface et encapsulant au moins partiellement chacun de la pluralité de composants semi-conducteurs.

2. Dispositif d'antenne (100) selon la revendication 1, dans lequel le matériau de moulage est disposé sur des surfaces latérales (128) de chacun de la pluralité de composants semi-conducteurs perpendiculaires à la troisième surface, et sur au moins une partie d'une quatrième surface (121) de chacun des composants semi-conducteurs opposée à la troisième surface.

3. Dispositif d'antenne (100) selon la revendication 2, comprenant en outre une couche de redistribution (154) formée sur le matériau de moulage et espacée de la quatrième surface par une épaisseur d'une partie du matériau de moulage qui est disposée sur la quatrième surface.

4. Dispositif d'antenne (100) selon la revendication 2, dans lequel :
le matériau de moulage formé sur au moins une partie de la quatrième surface est formé sur une première partie de la quatrième surface ;
une deuxième partie de la quatrième surface (160) est en interface avec l'air ; et
chacun de la pluralité de composants semi-conducteurs comporte des circuits actifs (402) situés directement derrière la deuxième partie de la quatrième surface, et éventuellement dans lequel la première partie de la quatrième surface est une partie périphérique de la quatrième surface, et la deuxième partie de la quatrième surface qui est en interface avec l'air est une partie centrale de la quatrième surface.

5. Dispositif d'antenne (100) selon la revendication 2, dans lequel :
le dispositif d'antenne comprend en outre des piliers métalliques (150a, 150b) formés sur la quatrième surface de chacun de la pluralité de composants semi-conducteurs pour former des connexions électriques, le matériau de moulage entourant les piliers métalliques sur la quatrième surface ; ou
le matériau de moulage est en outre disposé entre la troisième surface de chacun des composants semi-conducteurs et la deuxième surface du substrat d'antenne ; ou
le dispositif d'antenne comprend en outre un matériau de sous-remplissage, différent du matériau de moulage, dans une région (436) située entre la deuxième surface du substrat d'antenne et la troisième surface de chacun des composants semi-conducteurs.

6. Dispositif d'antenne (100) selon la revendication 1, dans lequel le substrat d'antenne comporte un plan de masse (118) qui est situé derrière la deuxième surface et/ou qui forme au moins une partie de la deuxième surface, le plan de masse comportant une pluralité d'ouvertures (412) à travers lesquelles la pluralité de composants semi-conducteurs est couplée à la pluralité d'éléments d'antenne à travers les vias.

7. Dispositif d'antenne (100) selon la revendication 1, dans lequel la pluralité de composants semi-conducteurs est une pluralité de puces de circuit intégré radiofréquence, RFIC, (122, 122', 530, 172, 325, 325', 325") comportant chacune au moins un amplificateur et/ou au moins un déphaseur.

8. Dispositif d'antenne (100) selon la revendication 7, dans lequel :
la pluralité de puces RFIC comporte des puces d'amplification (122, 122', 530) comprenant chacune un premier matériau semi-conducteur, et des puces de déphasage (172, 325, 325', 325") comprenant chacune un deuxième matériau semi-conducteur différent et étant couplées chacune à au moins une des puces d'amplification ; ou
le dispositif d'antenne comprend en outre un pilier métallique (150b) formé sur une quatrième surface (121) opposée à la troisième surface d'une première des puces RFIC (122), couplé à un pilier métallique formé sur une quatrième surface opposée à la troisième surface d'une deuxième des puces RFIC (325), à travers une couche de redistribution (154b) formée sur une surface (426) du matériau de moulage formé sur les quatrièmes surfaces des première et deuxième des puces RFIC.

9. Dispositif d'antenne (100) selon la revendication 7, comprenant en outre un blindage contre le rayonnement (505, 505') situé entre une dite puce RFIC et la deuxième surface du substrat d'antenne, et éventuellement dans lequel le blindage contre le rayonnement (505, 505') est composé d'au moins un élément parmi le tungstène et le tantale.

10. Dispositif d'antenne (100) selon la revendication 7, comprenant en outre :
un blindage contre le rayonnement (505') situé entre une dite puce RFIC et la deuxième surface du substrat d'antenne ; et
une couche de redistribution, RDL, (560) située entre le blindage contre le rayonnement et la puce RFIC, et éventuellement comprenant en outre :
des piliers métalliques supplémentaires (150m, 150p) situés entre la RDL et une surface inférieure de la puce RFIC, et couplés à une autre des puces RFIC à travers la RDL, la RDL comportant éventuellement des pistes conductrices de type fan-out à partir de chacun de la pluralité de composants semi-conducteurs.

11. Dispositif d'antenne (100) selon la revendication 7, comprenant en outre :
un blindage contre le rayonnement (505") situé entre une dite puce RFIC et la deuxième surface du substrat d'antenne ;
une couche de redistribution, RDL, (560) située entre le blindage contre le rayonnement et la puce RFIC ; et
un matériau de moulage supplémentaire (126a) situé entre le blindage contre le rayonnement et la RDL.

12. Dispositif d'antenne (100) selon la revendication 1, dans lequel :
la pluralité de composants semi-conducteurs comporte chacun une quatrième surface sur un côté opposé à la troisième surface ; et
le dispositif d'antenne comprenant en outre une carte de câblage imprimé, PWB, (130), qui fournit des signaux de commande et/ou des tensions de polarisation aux composants semi-conducteurs à travers une couche de redistribution, RDL, (154) formée sur le matériau de moulage couplé à un pilier métallique formé sur la quatrième surface de chacun des composants semi-conducteurs.

13. Dispositif d'antenne (100) selon la revendication 1, comprenant en outre une carte de câblage imprimé, PWB, (130) et dans lequel le réseau de formation de faisceaux comprend en outre une portion de combineur/diviseur (180) au moins partiellement encapsulée par le matériau de moulage entre la deuxième surface du substrat d'antenne et la PWB.

14. Dispositif d'antenne (100) selon la revendication 1, dans lequel :
le substrat d'antenne comporte une région de couche de redistribution, RDL, (960) proche de la deuxième surface, destinée à acheminer des signaux de commande et/ou des tensions de polarisation vers la pluralité de composants semi-conducteurs (122') ; et
le dispositif d'antenne comprenant en outre une carte de câblage imprimé, PWB, (130) qui fournit les signaux de commande et/ou les tensions de polarisation aux composants semi-conducteurs à travers la région RDL et des vias (942, 944), au sein du matériau de moulage, connectés à la région RDL.

15. Dispositif d'antenne (100) selon la revendication 14, comprenant en outre une liaison filaire (933) fixée à un contact électrique (931) sur une quatrième surface (121) d'un premier des composants semi-conducteurs (122') opposé à la troisième surface, la liaison filaire couplant le premier des composants semi-conducteurs à un deuxième des composants semi-conducteurs (325).
